# EUROPEAN PATENT SPECIFICATION

(11) **EP 0 768 714 B1**
(45) Date of publication and mention of the grant of the patent: **17.09.2003**
(21) Application number: 95830418.0
(22) Date of filing: 09.10.1995
(51) Int. Cl.: H01L 29/06, H01L 21/225

(54) **Construction method for power devices with deep edge ring**
Herstellungsverfahren für Leistungsanordnung mit Schutzring
Méthode de fabrication d'un dispositif de puissance avec anneau de guide profond

(43) Date of publication of application: 16.04.1997
(73) Proprietor: Consorzio per la Ricerca sulla Microelettronica nel Mezzogiorno - CoRiMMe, 95121 Catania (IT)
(72) Inventor: Franco, Giovanni, I-95030 Tremestieri Etneo (Catania) (IT); Camalleri, Cateno Marco, I-95100 Catania (IT); Frisina, Ferruccio, I-95030 Sant'Agata li Battiati (Catania) (IT)
(74) Representative: Modiano, Guido, Dr.-Ing.

(56) References cited:
- EP-A- 0 632 503
- US-A- 4 605 948
- US-A- 4 927 772
- PATENT ABSTRACTS OF JAPAN vol. 008 no. 053 (E-231) ,9 March 1984 & JP-A-58 206174 (TOKYO SHIBAURA DENKI KK) 1 December 1983,
- SEMICONDUCTOR SCIENCE AND TECHNOLOGY, APRIL 1993, UK, vol. 8, no. 4, ISSN 0268-1242, pages 488-494, GALVAGNO G ET AL 'Diffusion and outdiffusion of aluminium implanted into silicon'

## Description

The present invention relates to a construction method for power devices with deep edge ring, particularly for high-voltage power devices in MOS technology.

For all high-voltage power devices, particularly for those manufactured with MOS technology, where the output resistance is strongly influenced by resistivity, it is essential to achieve high breakdown efficiency, that is to say, a high ratio between the measured breakdown and the theoretical breakdown, of a flat junction.

One of the methods currently in use entails the formation of floating rings manufactured simultaneously with the body of the device and having the same depth as said body. These rings therefore have a doping concentration that is equal to that of the body.

An improvement in breakdown efficiency when using this method is achieved by increasing the number of floating rings.

This increase in the rings is difficult to perform, since the spacing between the various rings must be fixed.

Another method being used instead entails the provision of structures having rings that are coupled to the body. In this case, since the doping concentration of the rings must be much lower than that of said body, the rings are produced separately from the body.

Due to this lower concentration of the rings with respect to the body, for an equal thermal process, the depth of the rings is smaller than that of the body, so that in the junction point between the body and the first ring a peak in the electrical field is provided that decreases edge efficiency.

An improvement in breakdown efficiency and therefore in the evolution of the electrical fields can be achieved by providing one or more rings the junction depth whereof is greater than the depth of the body of said device. This allows to reduce the electrical field in the critical point where the body and the ring join, thus increasing edge efficiency.

Both in the first and in the second methods described above, it is possible to use boron as a dopant without requiring high thermal budgets.

In the third method, instead, where the ring has a greater junction depth than the body, the ring is formed before the body and requires diffusion processes having a high thermal budget (several tens of hours at temperatures above 1100° C).

A drawback of this treatment, in addition to the greater complexity of the production process, which is therefore less easy to carry out in industrial practice, is that the doping profiles of the drain are altered dramatically due to the out diffusion of the substrate.

The solution currently adopted to increase breakdown efficiency consists in replacing the dopant both for the body and for the rings: the dopant being used is aluminum. The implantation of aluminum ions leads to low electrical activity, which is a direct consequence of various phenomena, the most important whereof is the escape of aluminum ions from the surface.

In order to obviate this drawback, layers of dielectric material are used as a covering to prevent out diffusion, particularly layers of oxide-nitride-oxide or sipos.

Patent Abstracts of Japan, Vol. 008 no. 053 (E-231), 9 March 1984 & JP-A-58 206 174, 1 December 1983, disclose a semiconductor device and method thereof to enhance the withstand voltage and reduce the leakage current of the device.

US-A-4 605 948 discloses a semiconductor structure for electric field distribution, wherein a PH junction intercepts a semiconductor wafer surface.

A principal aim of the present invention is therefore to provide a construction method for power devices with deep edge ring having a high breakdown efficiency with low ion implantation energies.

Within the scope of this aim, an object of the present invention is to provide a construction method for power devices with deep edge ring that occurs in a single thermal process to form the body and the ring.

Another object of the present invention is to provide a construction method for power devices with deep edge ring that avoids the loss of aluminum from the surface of the silicon and therefore high ion implantation energies.

Another object of the present invention is to provide a construction method for power devices with deep edge ring without having to resort to covering layers of dielectric.

Another object of the present invention is to provide a method that is highly reliable and relatively easy to carry out at competitive costs.

This aim, these objects, and others which will become apparent hereinafter are achieved by a construction method for power devices with deep edge ring, characterized in that it comprises the following steps:
(a) the growth of a lightly doped N-type epitaxial layer on a heavily doped N-type substrate;
(b) the growth of an oxide on the upper portion of said epitaxial layer;
(c) the masked implantation of boron ions;
(d) an oxide etching to expose regions for aluminum ion implantation;
(e) the growth of a layer of preimplantation oxide;
(f) the masking of the body regions with a layer of photosensitive material and the implantation of aluminum ions; and
(g) a single thermal diffusion process for forming a layer of thermal oxide above said epitaxial layer and for simultaneously forming at least one deep aluminum ring and the adjacent body region doped with boron.

Further characteristics and advantages of the invention will become apparent from a preferred but not exclusive embodiment of the method according to the invention, illustrated only by way of non-limitative example in the accompanying drawings, wherein:
figure 1 is a view of the execution of a first conventional method for achieving high breakdown efficiency in high-voltage power devices;
figure 2 is a view of the execution of a second conventional method for achieving high breakdown efficiency in high-voltage power devices;
figure 3 is a view of the execution of a third conventional method for achieving high breakdown efficiency in high-voltage power devices;
figure 4 is a view of the execution of a method for achieving high breakdown efficiency by using the method according to the invention;
figures 5a-5c are views of the various steps of the method according to the invention; and
figure 6 is a view of the application of the method according to the invention for producing a VIPOWER (Vertical Intelligence Power) device.

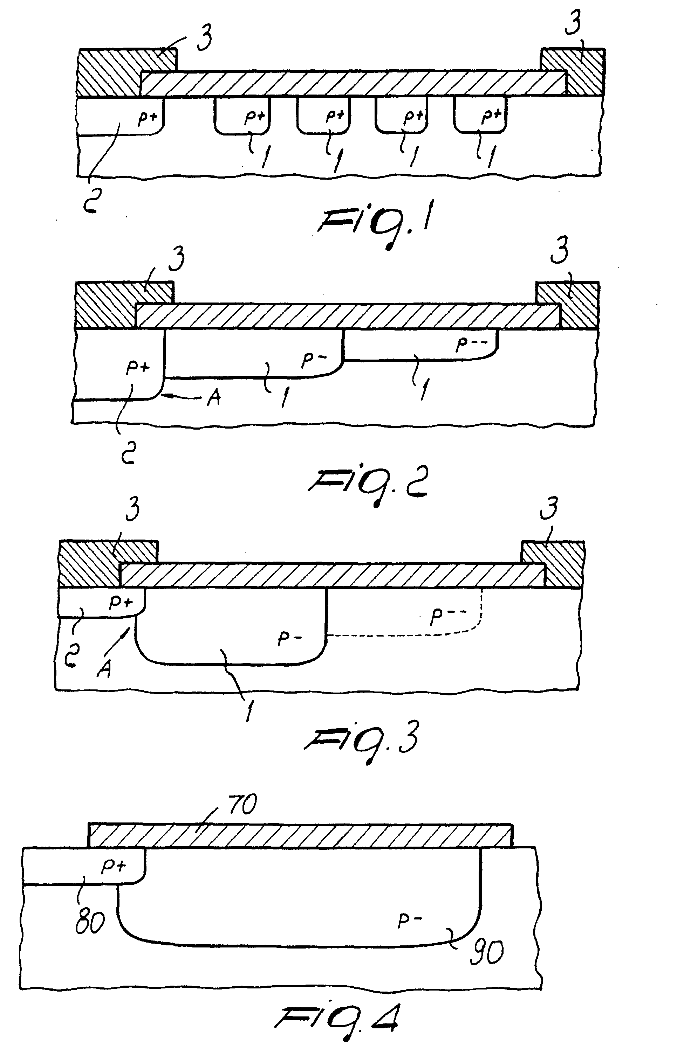

Figure 1 is a view of a first conventional method for achieving high breakdown efficiency, in which floating rings 1 are formed simultaneously with the body 2 of the high-voltage power device. Doping of the body 2 and of the rings 1 is performed with P-type material having an equal concentration. The body 2 and the rings accordingly have the same depth.

The reference numeral 3 designates the metallic contacts.

Figure 2 is a view of a second conventional method for achieving high breakdown efficiency, wherein the rings 1 are formed separately with respect to the body 2 and are coupled thereto. The concentration of the rings decreases starting from the body 2 and therefore the depth of the rings 1 is smaller than that of the body and decreases. This is possible by using two separate implantations for the two rings having different concentrations.

The material being used as a dopant in both of the above described methods is boron.

Figure 3 is a view of a third conventional method for forming a deep edge ring 1 lying adjacent to the body 2 of the power device. In this case, the ring (or the rings) is formed prior to the formation of the body and requires diffusion processes at very high temperatures (above 1100° C) for long periods. This process dramatically alters the doping profiles of the drain due to the out diffusion of the substrate.

Figure 4 is instead a view of the production of one or more deep edge rings with the method according to the invention.

In this last figure, the reference numeral 80 designates the body (which was designated by the reference numeral 1 in the previous figures), the reference numeral 70 designates an oxide layer, and the reference numeral 90 designates a deep edge ring formed with the material and the method according to the present invention.

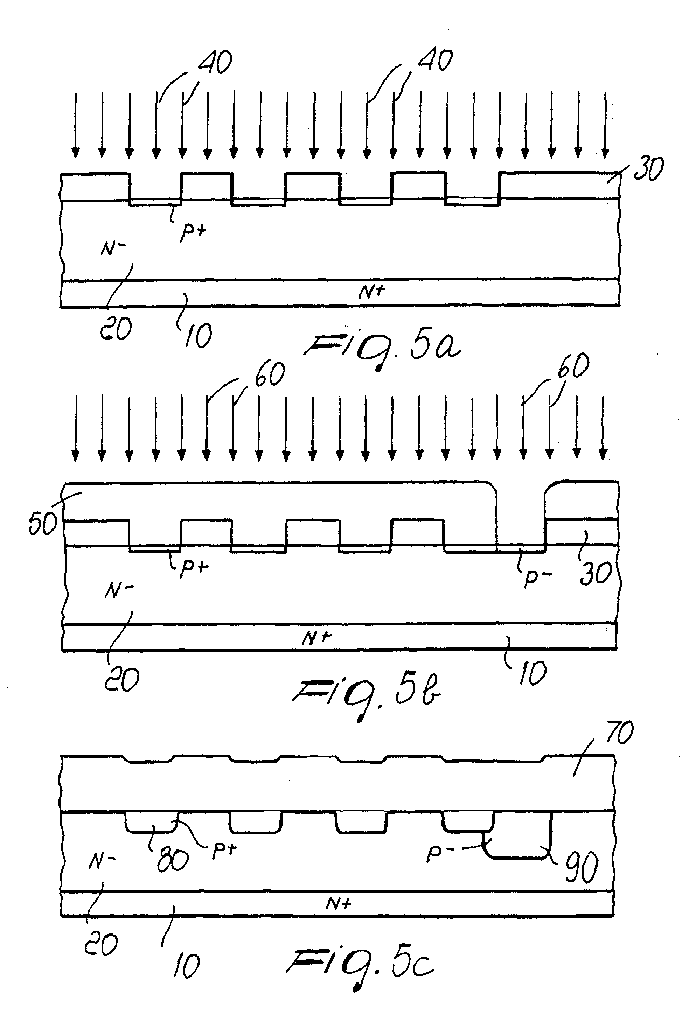

With reference to figures 5a-5c, the method according to the invention comprises the following steps.

First of all (figure 5a), the epitaxial layer 20 of appropriate resistivity (10-100 ohm/cm) and thickness (10-100 µm) is grown on a substrate 10 of the heavily doped N+ type; these values depend on the breakdown voltage of the device. The epitaxial layer 20 is of the lightly doped N type.

Thereafter, a layer of oxide 30 with a thickness of approximately 1 µm is grown. Advantageously, the oxide used is silicon dioxide (SiO₂).

During the subsequent step, the body photoetching is exposed and boron 40 is implanted in high doses (1ö5E15 Atm/sq cm).

The boron implantation is followed by an oxide etching step to expose the regions where aluminum ions must be implanted, said ions constituting the aluminum ring.

At this point, a layer of preimplantation oxide of appropriate thickness, between 100 and 1000 Å, is grown.

The body regions are then masked with photosensitive material (resist) 50 and aluminum ions 60 are implanted with a dose between 1E13 and 1E15 and an energy of 60 to 250 keV.

This is followed by a single thermal diffusion process, which is advantageously performed in a mixed inert-oxidizing environment that allows the formation of a layer of thermal oxide 70 that is approximately 1 µm thick; the P+/N- junctions 80, formed by boron, and one or more P-/N- junctions 90, formed by aluminum, are produced at the same time.

The junctions 80 formed with boron have a depth Xⱼ, whereas the junctions 90 formed with aluminum have a depth 3Xⱼ that is therefore three times the depth of the boron junctions.

The P-/N- junction 90 constitutes the desired edge ring.

In this manner, it is evident that the presence of aluminum inside the crystalline matrix of the silicon, after high-temperature thermal processes, is possible from ion implantation energy values of approximately 60 keV, without the aid of surface layers of poly, sipos, o-n-o as shown and explicitly stated in the documents of the prior art.

Likewise, the method according to the invention can be applied to structures of the VIPOWER type.

The edge structure in such devices is provided, according to a conventional method, by a P-type ring with two layers that are obtained with two different photomaskings and implantations.

The ring thus obtained is therefore constituted by two layers: one is formed later, after a first epitaxial growth and the formation of the P-type buried layer, and the other layer is formed after a second epitaxial growth. Said ring, which is produced by the sum of said two layers, is less deep than the P-type buried layer.

For further details regarding the conventional method for producing VIPOWER structures, reference should be made to U.S. Patent No. 5,489,799 in the name of the same Applicant.

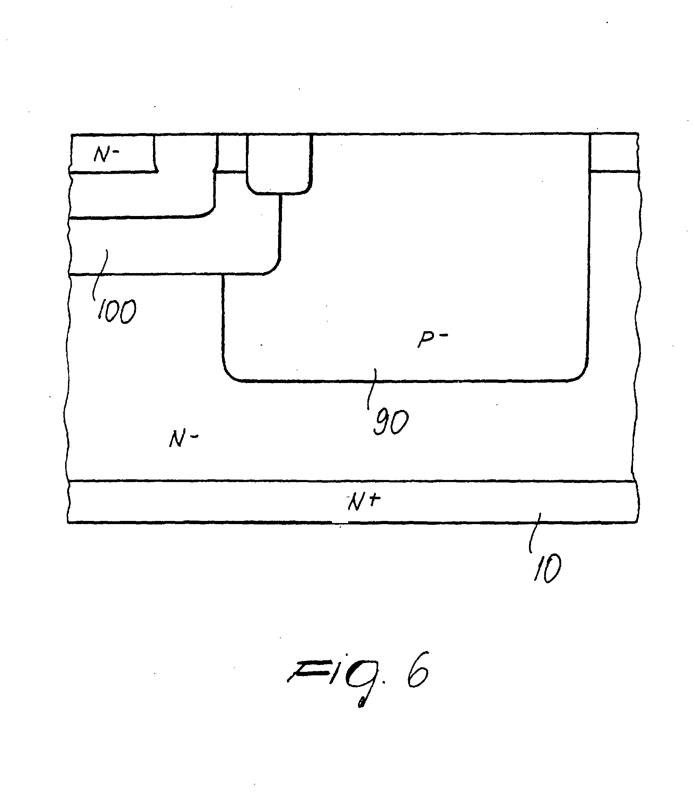

By using the method according to the invention, applied to VIPOWER structures, a configuration such as the one shown in figure 6, in which the edge ring is again designated by the reference numeral 90, is obtained.

This last figure shows that the edge ring obtained is now formed as a single layer that is deeper than the P-type buried layer mentioned above, designated here by the reference numeral 100.

In this manner, the application of the method according to the invention to VIPOWER structures allows to provide a ring (or rings) deeper than the P-type buried layer and to eliminate a photoetching step, since said ring can now be produced as a single layer, differently from what occurs in the conventional method.

In practice it has been observed that the method according to the invention fully achieves the intended aim, since it allows to achieve high breakdown efficiency, forming the deep ring or rings simultaneously with the body of the device, in a single thermal process, using boron and aluminum as dopants.

The method according to the invention allows to achieve deep junctions with low ion implantation energies, avoiding the loss of aluminum from the surface and the consequent need for high implantation energies.

The use of a layer of oxide during aluminum ion implantation allows to avoid the use of layers of dielectric, which are used in conventional processes.

The method thus conceived is susceptible of numerous modifications and variations, all of which are within the scope of the inventive concept.

Thus, for example, by using a VLD (Variation Lateral Doping) method it is possible to replace the single deep ring (previously designated by the reference numeral 90) with constant concentration with a variable-concentration ring.

Finally, all the details may be replaced with other technically equivalent elements.

In practice, the materials employed, so long as they are compatible with the specific use, as well as the dimensions, may be any according to the requirements and the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A construction method for power devices with deep edge ring, **characterized in that** it comprises the following steps:
(a) the growth of a lightly doped N-type epitaxial layer (20) on a heavily doped N-type substrate (10);
(b) the growth of an oxide (30) on. the upper portion of said epitaxial layer (20);
(c) the masked implantation of boron ions (40);
(d) an oxide etching to expose regions for aluminum ion implantation;
(e) the growth of a layer of preimplantation oxide;
(f) the masking of the body regions with a layer of photosensitive material (50) and the implantation of aluminum ions (60); and
(g) a single thermal diffusion process for forming a layer of thermal oxide (70) above said epitaxial layer (20) and for simultaneously forming at least one deep aluminum ring (90) and the adjacent body region doped with boron (80).

2. The method according to claim 1, **characterized in that** said at least one deep ring of aluminum (90) has a constant concentration.

3. The method according to claim 1, **characterized in that** said step for forming at least one deep ring of aluminum (90) is performed according to a variation lateral doping (VLD) technique.

4. The method according to claim 3, **characterized in that** said at least one deep ring of aluminum (90) formed by virtue of said variation lateral doping (VLD) technique is a deep ring with variable concentration.

5. The method according to claim 1, **characterized in that** the oxide (30) grown during the step for the growth of oxide on said epitaxial layer (20) is silicon dioxide.

6. The method according to claim 1, **characterized in that** the masking for the implantation of said boron ions (40) occurs by virtue of photosensitive material.

7. The method according to claim 1, **characterized in that** said preimplanted oxide layer grown during said preimplantation oxide growth step has a thickness of approximately 100-1000 A.

8. The method according to claim 1, **characterized in that** said aluminum ion (60) implantation step includes the implantation of a dose of approximately 1E13 - 1E15 Atm/sq cm of aluminum ions (60).

9. The method according to claim 8, **characterized in that** said aluminum ion (60) implantation step occurs with an energy of approximately 60-250 keV.

10. The method according to claim 1, **characterized in that** said single thermal process occurs in a mixed inert-oxidizing environment.

11. The method according to claim 1, **characterized in that** said layer of thermal oxide (70) has a thickness of approximately 1 µm.

## Patentansprüche

1. Herstellungsverfahren für Leistungsanordnungen mit einem Ring mit tiefer Kante, **dadurch gekennzeichnet, dass** es die folgenden Schritte aufweist:
(a) das Wachstum einer leicht dotierten N-Typ Epitaxialschicht (20) auf einem stark dotierten N-Typ Substrat (10);
(b) das Wachstum eines Oxids (30) auf den oberen Abschnitt dieser Epitaxialschicht (20);
(c) die maskierte Implantation von Bor-lonen (40);
(d) ein Oxidätzen, um Regionen einer Aluminium-Ionenimplantation auszusetzen;
(e) das Wachstum einer Schicht aus Preimplantationsoxid;
(f) das Maskieren der Körperregionen mit einer Schicht von photosensitivem Material (50) und die Implantation von Aluminium-Ionen (60); und
(g) ein einzelner thermischer Diffusionsprozess zum Bilden einer Schicht von Hitzeoxiden (70) über der Epitaxialschicht (20) und zum simultanen Bilden wenigstens eines tiefen Aluminiumrings (90) und der benachbarten Körperregion, die mit Bor (80) dotiert ist.

2. Verfahren nach Anspruch 1, **dadurch gekennzeichnet, dass** der wenigstens eine tlefe Aluminiumring (90) eine konstante Konzentration aufweist.

3. Verfahren nach Anspruch 1, **dadurch gekennzeichnet, dass** der Schritt des Bildens wenigstens eines tiefen Rings von Aluminium (90) gemäß einer Technik der Variation seitlicher Dotierung (variation lateral doping - VLD) durchgeführt wird.

4. Verfahren nach Anspruch 3, **dadurch gekennzeichnet**, das der wenigstens eine tiefe Ring aus Aluminium (90), der mittels der Technik der Variation seitlicher Dotierung (VLD) gebildet worden ist, ein tiefer Ring mit variabler Konzentration ist.

5. Verfahren nach Anspruch 1, **dadurch gekennzeichnet, dass** das Oxid (30), das während des Schritts des Wachstums von Oxid auf der Epitaxialschicht (20) gewachsen ist, Siliziumdioxid ist.

6. Verfahren nach Anspruch 1, **dadurch gekennzeichnet, dass** das Maskieren für die Implantation von Bor-Ionen (40) aufgrund von photosensitivem Material erfolgt.

7. Verfahren nach Anspruch 1, **dadurch gekennzeichnet, dass** preimplantierte Oxidschicht, die während des Schritts des Wachstums Preimplantationsoxids gewachsen ist, eine Dicke von ungefähr 100 bis 1000 A aufweist.

8. Verfahren nach Anspruch 1, **dadurch gekennzeichnet, dass** der Schritt der Aluminium-lon- (60) -implantation die Implantation einer Dosis von ungefähr 1E13 - 1E15 Atm/sq cm von Aluminium-Ionen (60) einschließt.

9. Verfahren nach Anspruch 8, **dadurch gekennzeichnet, dass** der Schritt der Aluminium-Ion- (60) -Implantation mit einer Energie von 60 bis 250 keV erfolgt.

10. Verfahren nach Anspruch 1, **dadurch gekennzeichnet, dass** der einzelne thermische Prozess in einer gemischten Inert-oxidierenden Umgebung auftritt

11. Verfahren nach Anspruch, **dadurch gekennzeichnet, dass** die Hitzeoxidschicht (70) eine Dicke von ungefähr 1 µm aufweist.

## Revendications

1. Procédé de fabrication de dispositifs de puissance comportant un anneau latéral profond, **caractérisé en ce qu'**il comprend les étapes suivantes :
(a) la croissance d'une couche épitaxiale (20) de type N légèrement dopée sur un substrat de type N fortement dopé (10) ;
(b) la croissance d'un oxyde (30) sur la partie supérieure de la couche épitaxiale (20) ;
(c) l'implantation ionique de bore (40), en utilisant un masque ;
(d) une gravure d'oxyde pour mettre à nu des régions pour une implantation ionique d'aluminium ;
(e) la croissance d'une couche d'oxyde pré-implantation ;
(f) le masquage des régions de corps avec une couche de matériau photosensible (50) et l'implantation ionique d'aluminium (60) ; et
(g) un unique procédé de diffusion thermique pour former une couche d'oxyde thermique (70) au-dessus de la couche épitaxiale (20) et pour former simultanément au moins un anneau d'aluminium profond (90) et la région de corps adjacente dopée au bore (80).

2. Procédé selon la revendication 1, **caractérisé en ce que** ledit au moins un anneau profond d'aluminium (90) a une concentration constante.

3. Procédé selon la revendication 1, **caractérisé en ce que** ladite étape pour former au moins un anneau profond d'aluminium (90) est réalisée selon une technique de variation de dopage latéral (VLD).

4. Procédé selon la revendication 3, **caractérisé en ce que** ledit au moins un anneau profond d'aluminium (90) formé au moyen de ladite technique de variation de dopage latéral (VLD) est un anneau profond de concentration variable.

5. Procédé selon la revendication 1, **caractérisé en ce que** l'oxyde (30) amené à croître durant l'étape de croissance d'oxyde sur la couche épitaxiale (20) est du dioxyde de silicium.

6. Procédé selon la revendication 1, **caractérisé en ce que** le masquage pour l'implantation des ions de bore (40) est réalisé au moyen de matériau photosensible.

7. Procédé selon la revendication 1, **caractérisé en ce que** la couche d'oxyde pré-implantation amenée à croître pendant l'étape de croissance d'oxyde pré-implantation a une épaisseur d'approximativement 100-1000 Å.

8. Procédé selon la revendication 1, **caractérisé en ce que** l'étape d'implantation ionique d'aluminium (60) comprend l'implantation d'une dose d'approximativement 10¹³ - 10¹⁵ atomes/cm² d'ions d'aluminium (60).

9. Procédé selon la revendication 8, **caractérisé en ce que** l'étape d'implantation ionique d'aluminium (60) est réalisée sous une énergie d'approximativement 60-250 keV.

10. Procédé selon la revendication 1, **caractérisé en ce que** le procédé thermique unique est réalisé en atmosphère mixte inerte-oxydante.

11. Procédé selon la revendication 1, **caractérisé en ce que** la couche d'oxyde thermique (70) a une épaisseur d'approximativement 1 µm.
